# EUROPÄISCHE PATENTSCHRIFT

(11) **EP 1 378 063 B1**
(45) Veröffentlichungstag und Bekanntmachung des Hinweises auf die Patenterteilung: **05.04.2006**
(21) Anmeldenummer: 02735030.5
(22) Anmeldetag: 05.04.2002
(51) Int. Cl.: H03M 1/10, G01D 3/02

(54) **VERFAHREN UND SCHALTUNG ZUR LINEARISIERUNG VON NICHTLINEAREN KENNLINIEN**
METHOD AND CIRCUIT FOR LINEARISING NON-LINEAR CURVES
PROCEDE ET CIRCUIT PERMETTANT LA LINEARISATION DE COURBES CARACTERISTIQUES NON LINEAIRES

(30) Priorität: 10.04.2001 DE 10118000; 20.03.2002 DE 10212461
(43) Veröffentlichungstag der Anmeldung: 07.01.2004
(73) Patentinhaber: Micro-Epsilon Messtechnik GmbH & Co. KG, 94496 Ortenburg (DE)
(72) Erfinder: HRUBES, Franz, 94094 Rotthalmünster (DE); WISSPEINTNER, Karl, 94496 Ortenburg (DE)
(74) Vertreter: Naumann, Ulrich
(86) Internationale Anmeldenummer: PCT/DE2002/001246
(87) Internationale Veröffentlichungsnummer: WO 2002/084883

(56) Entgegenhaltungen:
- DE-A- 2 544 591
- DE-A- 2 616 224
- DE-A- 4 401 525
- DE-C- 3 940 376
- US-A- 4 873 655
- US-A- 5 848 383

## Beschreibung

Die Erfindung betrifft ein Verfahren und eine Schaltungsanordnung zur Linearisierung von nichtlinearen Kennlinien mit einer Linearisierungsschaltung, wobei die Kennlinie die Beziehung zwischen Eingangssignalen und Ausgangssignalen eines Bauteils, insbesondere eines Sensors, darstellt und wobei ein Ausgangssignal jeweils einem Eingangssignal zugeordnet ist,.

Verfahren und Schaltungen zur Linearisierung von nichtlinearen Kennlinien sind in der Praxis seit langem bekannt, da Bauteile häufig keinen linearen Zusammenhang zwischen dem Eingangssignal und dem Ausgangssignal liefern. Dies gilt insbesondere für Sensoren, bei denen im Allgemeinen zwischen der zu messenden physikalischen Größe, d.h. dem Eingangssignal des Sensors, und der Änderung des elektrischen Signals, das der für die Messung verwendete Sensor als Ausgangssignal liefert, ein nichtlinearer Zusammenhang besteht. In den meisten Fällen ergeben sich über dem Messwert nichtlineare stetig steigende oder stetig fallende Signale, in der Regel Spannungen und/oder Ströme.

Mit den Möglichkeiten heutiger A/D-Wandler - Analog-Digital-Wandler - und D/A-Wandler - Digital-Analog-Wandler - und bei der Verwendung von Mikroprozessoren ist eine verhältnismäßig einfache rechnerische Linearisierung von Kennlinien dann möglich, wenn die Kennlinienform genau bekannt ist. Alternativ hierzu ist es auch möglich, mit wenigen Referenzwerten und einer gegebenen Grundformel eine rechnerische Linearisierung von Kennlinien mittel eines Mikroprozessors durchzuführen.

Diese Verfahren sind jedoch dahingehend problematisch, dass es merkliche Einschränkungen im Hinblick auf die Auflösung und die Geschwindigkeit der Linearisierung gibt. Ist die Kennlinie nämlich stark gekrümmt, so ist eine entsprechend hohe Auflösung des A/D-Wandlers erforderlich. Derartige Präzisions-A/D-Wandler mit einer Auflösung von mehr als 16 Bit sind verhältnismäßig teuer. Ferner steigt der Preis solcher Präzisions-A/D-Wandler stark mit der Verarbeitungsgeschwindigkeit des A/D-Wandlers. Soll nun ein Signal mit einer Auflösung von 17 oder mehr Bit bei gleichzeitig hoher Signalfrequenz, d. h. bis über 200 kHz, verarbeitet werden, so ist dies mit den zur Zeit erhältlichen A/D-Wandlern bei extrem hohen Kosten oder zum Teil sogar gar nicht möglich.

Alternativ werden Kennlinien auch seit langem mit analogen Linearisierungsschaltungen linearisiert, da mit analogen Bauteilen eine hohe Auflösung und Genauigkeit bei gleichzeitig hoher Verarbeitungsgeschwindigkeit realisierbar ist. Dieses Verfahren ist jedoch dahingehend problematisch, dass der Abgleich der Linearisierungsschaltung eine genaue Einstellung der Arbeitspunkte der Linearisierungsschaltung erfordert, was nur durch einen manuellen iterativen Abgleich, d. h. durch vielfach wiederholtes Eingeben verschiedener über den Messbereich verteilter Eingangssignale mit jeweils verbundenen Einstellungen von Potentiometern für den Nullpunkt, die Verstärkung und geringster Linearitätsabweichung der linearisierten Kennlinie, möglich ist. Dieser Vorgang kann besonders bei ungeübten und unerfahrenen Bedienem sehr lange dauern und bei Fehlbedienung sogar scheitern. Zudem ist es nur sehr schwer oder teilweise sogar gar nicht möglich, bei jedem Abgleichsschritt immer wieder exakt die selben physikalischen Eingangssignale einzustellen, beispielsweise den Abstand eines Sensors zu einem Messobjekt, wodurch sich der Abgleichsaufwand entsprechend stark vergrößert.

Die DE 25 44 591 zeigt eine Linearisierungsschaltung mit iterativem Abgleich gemäß dem Oberbegriff des Anspruchs 1.

Der vorliegenden Erfindung liegt daher die Aufgabe zugrunde, ein Verfahren sowie eine Schaltung zur Linearisierung von nichtlinearen Kennlinien der eingangs genannten Art anzugeben, wonach eine einfache und kostengünstige Linearisierung ermöglicht ist, und die auch bei schnell veränderlichen Messgrößen einsetzbar ist.

Erfindungsgemäß wird die voranstehende Aufgabe durch ein Verfahren zur Linearisierung von nichtlinearen Kennlinien mit den Merkmalen des Patentanspruches 1 gelöst. Danach ist das in Rede stehende Verfahren und ist die in Rede stehende Schaltung derart ausgestaltet und weitergebildet, dass das Einstellen der Linearisierungsschaltung im Wesentlichen automatisiert mittels einer Ablaufsteuerung erfolgt.

In erfindungsgemäßer Weise ist erkannt worden, dass das Einstellen der Linearisierungsschaltung in einer im Wesentlichen automatisierten Weise mittels einer Ablaufssteuerung eine besonders gute Auflösung bei hoher Genauigkeit und hoher Bearbeitungsgeschwindigkeit erreicht, wie dies bei einer analogen Linearisierungsschaltung möglich ist. Hohe Kosten, wie diese für sehr präzise A/D- oder D/A-Wandler anfallen, fallen in erfindungsgemäßer Weise nicht an. Zudem ermöglicht die Ablaufsteuerung einen im Wesentlichen automatisierten Abgleich der Kennlinie, wobei der Abgleich nunmehr nicht von dem Geschick des Bedieners abhängt und deshalb nicht mehr derart zeitaufwendig ist bzw. nicht mehr scheitern kann. Das erfindungsgemäße Verfahren vereinigt daher die Vorteile der bekannten Verfahren und dass ohne ihre Nachteile aufzuweisen.

In besonders vorteilhafter Weise könnte mindestens ein Ausgangssignal - Ist-Eingangswert - mittels der Ablaufsteuerung erfaßt und/oder gespeichert werden. Der Ist-Eingangswert entspricht demnach dem Ausgangssignal des Bauelements. Dies wäre insbesondere dahingehend vorteilhaft, dass die das Ausgangssignal erzeugenden Eingangssignale, z. B. bei einem Wegsensor der kleinste Messabstand, der mittlere Messabstand oder maximale Messabstand, nur jeweils einmal eingestellt werden müßten, wodurch beim Abgleich der Linearisierungsschaltung kein weiterer Aufwand zur exakten Wiedereinstellung der Eingangssignale bzw. der Messabstände anfällt.

Alternativ hierzu könnte mindestens ein Soll-Eingangswert, vorzugsweise über eine Eingabeeinheit, in die Ablaufsteuerung eingegeben werden. Bei der Eingabeeinheit könnte es sich hierbei beispielsweise um eine Tastatur oder ähnliches handeln. Dies wäre von besonderem Vorteil, wenn das Eingangssignal des Bauteils, beispielsweise der kleinste, der mittlere oder der maximale Messabstand, sowie das Ausgangssignal des Bauteils bzw. der Ist-Eingangswert bei diesen Messabständen bekannt ist. Der Soll-Eingangswert würde dann gleich dem Ausgangssignal gewählt werden. Der Soll-Eingangswert könnte allerdings auch von der Ablaufsteuerung generiert werden, beispielsweise unter Berücksichtigung des jeweiligen Ausgangssignals des Bauteils.

Der Soll-Eingangswert könnte besonders vorteilhafter Weise analogisiert werden, um mit dem Ist-Eingangswert verglichen zu werden und sodann an den Ist-Eingangswert angeglichen werden zu können. Hinsichtlich einer besonders einfachen Ausgestaltung könnte der Soll-Eingangswert dabei mittels eines D/A-Wandlers analogisiert werden. Bei dem D/A-Wandler könnte es sich hierbei um einen hochauflösenden D/A-Wandler handeln, der allerdings nicht besonders stabil sein muss und langsam sein darf. Alternativ könnte der Soll-Eingangswert mittels mindestens einer einstellbaren Signalquelle analogisiert werden. Dies wäre eine besonders kostengünstige Alternative, da kein teuer D/A-Wandler zur Analogisierung benötigt wird.

Im Rahmen einer besonders einfachen Ausgestaltung könnte die Signalquelle durch mindestens eine Referenzspannung und/oder mindestens einen vorzugsweise digital ansteuerbaren Potentiometer gebildet werden. Das Potentiometer könnte in besonders vorteilhafter Weise vorzugsweise mittels der Ablaufsteuerung in äquidistanten Stufen eingestellt werden.

In weiter vorteilhafter Weise könnte der Soll-Eingangswert mittels drei vorzugsweise digital ansteuerbaren Potentiometer eingestellt werden. Die Ausgangssignale der Potentiometer könnten dann mittels eines Summierers addiert werden. Hierbei könnte mittels eines der Potentiometer zunächst ein Grobabgleich, mittels des zweiten Potentiometers ein Feinabgleich und schließlich mittels des dritten Potentiometers ein Feinstabgleich erfolgen. Dabei könnte der Einstellbereich des Potentiometers für den Feinabgleich einer Stufe des Potentiometers für den Grobabgleich und der Einstellbereich des Potentiometers für den Feinstabgleich einer Stufe des Potentiometers für den Feinabgleich entsprechen.

Bei der Verwendung von digital ansteuerbaren Potentiometern mit beispielsweise 64 wählbaren äquidistanten Stufen, d. h. mit 6 Bit, könnte der Potentiometer für den Grobabgleich eine Spannung von beispielsweise 0 bis 10 Volt in 64 Stufen ä 156,25 mV liefern. Der Potentiometer für den Feinabgleich könnte dann eine Spannung von 0 bis 157 mV in 64 Stufen ä 2,45 mV liefern und der Potentiometer für den Feinstabgleich könnte eine Spannung von 0 bis 2,45 mV in 64 Stufen liefern. Damit würde sich die feinste Auflösung zu 0,0383 mV ergeben. Dies würde auf den 10 Voltbereich bezogen einer Auflösung von ca. 1 : 260.000 und damit 18 Bit entsprechen. Die Ausgangssignale der digitalen Potentiometer könnten mittels des Summierers addiert werden und somit den Soll-Eingangswert ergeben. Der abzuspeichernde Digitalwert des Soll-Eingangswerts würde sich dann aus den einzelnen Einstellungen der digitalen Potentiometer ergeben, die 3 x 6 Bit entsprechen. Ferner könnten auf diese Weise durch weitere digitale Potentiometer oder durch digitale Potentiometer mit mehr Stufen eine noch höhere Auflösung erreicht werden, es könnte beispielsweise bei 1024 und 256 Stufen ein Potentiometer eingespart werden.

Die beschriebene besonders vorteilhafte Ausgestaltung einer treppenförmigen Signaleinstellung des Soll-Eingangswerts mit exakt gleich großen Stufen ist jedoch dahingehend problematisch, da die Bauteiltoleranzen häufig zu groß sind. Daher müssen gewisse Überschneidungen der Teilbereiche realisiert werden, damit immer gewährleistet ist, dass beim Abgleich auch tatsächlich immer eine ganze Stufe abgedeckt ist. Da bei dem erfindungsgemäßen Verfahren kein exakter Messwert benötigt wird, sondern nur eine Vergleichsspannung - Soll-Eingangswert, die im Wesentlichen gleich dem Ist-Eingangswert ist, spielen solche Toleranzen, die lediglich Linearitäts- und Genauigkeitsfehlem entsprechen, keine Rolle, solange die erforderliche Auflösung gegeben ist.

Hinsichtlich eines besonders einfachen Abgleichs könnten die Einstellungen der Potentiometer, insbesondere in Verbindung mit dem zugehörigen Soll-Eingangswert und/oder einem Soll-Ausgangswert gespeichert werden. Auch wäre es möglich die Einstellungen in Verbindung mit dem Ist-Eingangswert zu speichern, so dass ein Abruf der Einstellungen in Verbindung mit den verschiedenen Werten möglich ist.

Im Hinblick auf einen besonders genauen und einfachen Abgleich könnten die Ist-Eingangswerte und/oder die Soll-Eingangswerte an ein vergleichendes Bauelement, vorzugsweise einen Komparator, angelegt werden. Der Soll-Eingangswert könnte sodann mittels des vergleichenden Bauelements mit dem Ist-Eingangswert verglichen werden.

Hinsichtlich einer besonders einfachen Ausgestaltung könnte die Ablaufsteuerung solange den Soll-Eingangswert, insbesondere iterativ, abgleichen, bis eine vorgegebene Abweichung zwischen dem Ist-Eingangswert und dem Soll-Eingangswert unterschritten wird. Somit wäre mittels dieses Verfahrens sowohl eine D/A-Wandlung als auch eine A/D-Wandlung von Signalen, d.h. von dem Ausgangssignal des Bauteils bzw. des Sensors, auf besonders kostengünstige Art und Weise möglich, da durch Aufruf der abgespeicherten Einstellwerte am Ausgang des D/A-Wandlers bzw. Summierers wieder dasselbe Signal anliegt, das dem jeweiligen Ausgangssignal des Bauteils entspricht. Prinzipiell könnten somit beliebig viele Ausgangssignale - Spannungen oder Ströme - gespeichert und wieder aufgerufen werden, ohne dass das Bauteil selbst wieder auf den gleichen Wert - z. B. den gleichen Messabstand - eingestellt werden muß. Hierdurch wäre es innerhalb eines gewissen Bereichs möglich, ein digitales in ein analoges sowie ein analoges in ein digitales Signal umzuwandeln. In besonders vorteilhafter Weise wären zur Linearisierung hierbei nur drei abgespeicherte Ausgangssignale bzw. Soll-Eingangs-/Soll-Ausgangswertepaare nötig.

Die Soll-Eingangswerte könnten in besonders vorteilhafter Weise als Anfangspunkt und/oder als Mittelpunkt und/oder als Endpunkt der linearisierten Kennlinie gewählt werden. Dies könnte dann beispielsweise dem kleinsten bzw. dem mittleren oder maximalen Messabstand des Sensors zu einem Messobjekt entsprechen. Alternativ hierzu könnten die Soll-Eingangswerte aus einem Teilbereich von Eingangssignalen der nichtlinearen Kennlinie gewählt werden. Dies wäre insbesondere dann von Vorteil, wenn nur Teilbereiche der Kennlinie linearisiertwerden sollen, da nur die Messungen in diesem Bereich von Interesse sind.

Die von der Ablaufsteuerung ausgegebenen Soll-Eingangswerte, könnten, vorzugsweise über einen Schalter, an den Eingang der Linearisierungsschaltung angelegt werden. Bei dem Schalter könnte sich um einen mittels der Ablaufsteuerung steuerbaren Schalter handeln, der wechselweise den von der Ablaufsteuerung ausgegeben Soll-Eingangswert oder das Ausgangssignal des Bauteils an die Linearisierungsschaltung anlegt. Das Ausgangssignal des Bauteils entspricht demnach auch dem Ist-Eingangswert der Linearisierungsschaltung.

Im Hinblick auf eine wiederum sehr einfache Ausgestaltung könnte mindestens ein zum Ist-Eingangswert zugehöriger Soll-Ausgangswert mittels der Ablaufsteuerung erfasst und/oder gespeichert werden. Der Soll-Ausgangswert könnte hierbei in den Arbeitspunkten, die gleichzeitig die Stützpunkte der linearisierten Kennlinie sind - d.h. für die Wertepaare in denen die nichtlineare Kennlinie gleich der linearisierten Kennlinie ist -, dem Ausgangssignal des Bauteils entsprechen. Das Erfassen und/oder das Speichern des Soll-Ausgangswerts könnte hierbei im Wesentlichen gleichzeitig mit dem Erfassen bzw. Speichern des zugehörigen Ist-Eingangswert erfolgen.

In Rahmen einer abermals besonders einfachen Ausgestaltung könnte ein Soll-Ausgangswert mittels Referenzsignalquellen eingestellt werden. Diese Referenzsignalquellen könnten hierbei die Soll-Ausgangswerte liefern, wenn diese exakt bekannt sind. Dies könnten beispielsweise der Messbereichsanfang, die Messbereichsmitte sowie das Messbereichsende, beispielsweise 0 Volt, 5 Volt bzw. 10 Volt, sein. Die einzelnen Soll-Ausgangswerte könnten dann mittels eines von der Ablaufsteuerung steuerbaren Schalters entsprechend dem anliegenden Soll-Eingangswerts aufgeschaltet werden. Alternativ hierzu könnten die Referenzsignalquellen einstellbar sein, wenn der Messbereichsanfang, die Messbereichsmitte und das Messbereichsende nicht exakt, sondern annähernd eingestellt werden können, jedoch die tatsächlichen Werte bekannt sind und somit auch die entsprechenden Soll-Ausgangswerte feststehen. Ein zum Ist-Eingangswert zugehöriger Soll-Ausgangswert könnte z.B. über eine Eingabeeinheit in die Ablaufsteuerung eingegeben werden. Dies wäre dann von besonderem Vorteil, wenn der Soll-Ausgangswert bekannt ist.

Im Hinblick auf eine abermals sehr einfache Ausgestaltung könnten die Soll-Eingangswerte mittels eines D/A-Wandlers analogisiert werden. Der. D/A-Wandler könnte hierbei eine geringe Auflösung und Genauigkeit aufweisen, beispielsweise 13 bis 14 Bit, weshalb der D/A-Wandler keine hohen Kosten verursachen würde.

Im Hinblick auf eine besonders gute Linearisierung könnten mittels eines vergleichenden Bauelements, insbesondere eines Komparators, die auf die Soll-Eingangswerte von der Linearisierungsschaltung ausgegebenen Ist-Ausgangswerte mit den Soll-Ausgangswerten verglichen werden. Das Ausgangssignal des vergleichenden Bauelements könnte dann durch die Ablaufsteuerung ausgewertet werden. Mittels der Ablaufsteuerung könnte sodann mindestens ein Abgleichsmittel eingestellt werden. Die Abgleichsmittel dienen hierbei zum Abgleichen der Linearisierungsschaltung, d.h. zum Einstellen der linearisierten Kennlinie.

Im Rahmen einer besonders einfachen Linearisierung könnte mindestens ein Abgleichsmittel zum Abgleich des Nullpunkts und/oder mindestens ein Abgleichsmittel zum Abgleich der Linearität und/oder mindestens ein Abgleichsmittel zum Abgleich der Steigung der linearisierten Kennlinie dienen. Hinsichtlich eines besonders einfachen Abgleichs der Linearisierungsschaltung könnte die Ablaufsteuerung die Abgleichsmittel mit Digitalimpulsen ansteuern.

Zum Abgleich der Linearisierungsschaltung könnte nunmehr die Ablaufsteuerung mittels der Abgleichsmittel für jedes Soll-Eingangs-/Soll-Ausgangswertepaar einen Abgleich der Linearisierungsschaltung solange durchführen, bis eine vorgegebene Abweichung zwischen dem Ist-Ausgangswert und dem Soll-Ausgangswert unterschritten wird.

In besonders vorteilhafter Weise könnte zunächst für ein erstes Soll-Eingangs-/Soll-Ausgangswertepaar das Abgleichsmittel zur Einstellung des Nullpunkts der linearisierten Kennlinie derart eingestellt werden, dass der Ist-Ausgangswert im Wesentlichen gleich dem Soll-Ausgangswert ist.

Ferner könnte sodann ein weiterer von der Ablaufsteuerung ausgegebener Soll-Eingangswert an die Linearisierungsschaltung angelegt werden. Im Wesentlichen gleichzeitig könnte der zugehörige von der Ablaufsteuerung ausgegebene Soll-Ausgangswert an das vergleichende Bauelement angelegt werden.

Nunmehr könnte wiederum der Ist-Ausgangswert der Linearisierungsschaltung des weiteren Soll-Eingangs-/Soll-Ausgangswertepaars an das vergleichende Bauelement angelegt werden. Das Ausgangssignal des vergleichenden Bauelements könnte wiederum durch die Ablaufsteuerung ausgewertet werden.

Nunmehr könnte aufgrund der Auswertung des Ausgangssignals des vergleichenden Bauelements das Abgleichsmittel zur Einstellung der Steigung der linearisierten Kennlinie derart eingestellt werden, dass der Ist-Ausgangswert im Wesentlichen gleich dem Soll-Ausgangswert ist.

Zum weiteren Abgleich der Linearisierungsschaltung könnte nun ein weiterer von der Ablaufsteuerung ausgegebener Soll-Eingangswert an die Linearisierungsschaltung angelegt werden. Im Wesentlichen gleichzeitig könnte der zugehörige von der Ablaufsteuerung ausgegebene Soll-Ausgangswert an das vergleichende Bauelement angelegt werden. Zum Abgleich könnte dann der Ist-Ausgangswert des weiteren Soll-Eingangs-/Soll-Ausgangswertepaars an das vergleichende Bauelement angelegt werden.

Das Ausgangssignal des vergleichenden Bauelements könnte wiederum in besonders vorteilhafter Weise durch die Ablaufsteuerung ausgewertet werden. Nach dieser Auswertung könnte das Abgleichsmittel zur Einstellung der Linearität der Kennlinie derart eingestellt werden, dass der Ist-Ausgangswert im Wesentlichen gleich dem Soll-Ausgangswert ist. Dies würde aufgrund der Auswertung des Ausgangssignals des vergleichenden Bauelements durch die Ablaufsteuerung und mittels der Ablaufsteuerung erfolgen. Ein erster Abgleich der Linearisierungsschaltung wäre somit erfolgt. Alternativ hierzu könnte aber auch der Abgleich derart erfolgen, dass ein Abgleich aller Abgleichsmittel zunächst für das erste Soll-Eingangs-/Soll-Ausgangswertepaar erfolgt und dann ein Abgleich aller Abgleichsmittel für die weiteren Soll-Eingangs-/Soll-Ausgangswertepaare erfolgt.

Hinsichtlich einer besonders vorteilhaften Ausgestaltung könnte nunmehr zum vollständigen Abgleich der Linearisierungsschaltung der Abgleich der Abgleichsmittel für die Soll-Eingangs-/Soll-Ausgangswertepaare solange wiederholt werden, bis für alle Soll-Ausgangswerte eine vorgegebene Abweichung zwischen dem Ist-Ausgangswert und dem Soll-Ausgangswert unterschritten wird.

Im Rahmen einer besonders universellen Ausgestaltung könnten in der Ablaufsteuerung unterschiedliche linearisierte Kennlinien gespeichert werden. Diese unterschiedlichen Kennlinien könnten dabei mittels des obig beschriebenen Verfahrens linearisiert worden sein. Zusätzlich oder alternativ hierzu könnten die linearisierten Kennlinien aber auch über die Eingabeeinheit in die Ablaufsteuerung eingegeben und dann gespeichert worden sein. Hierdurch könnte für bestimmte Anwendungen eine bereits linearisierte Kennlinien wieder abgerufen werden, beispielsweise bei einer Abstandsmessung gegen unterschiedliche Materialien, die jeweils eine andere Kennlinienform des Ausgangssignals des Bauteils mit sich bringt und die damit einen anderen Abgleich der Linearisierungsschaltung erfordert. Eine neue Einstellung von bekannten Abstandswerten wäre dabei nicht mehr erforderlich, da die entsprechenden Ausgangssignale des Bauelements bereits bekannt wären.

Hinsichtlich einer abermals einfachen Ausgestaltung könnte nach der Linearisierung der Kennlinie das Ausgangssignal des Bauteils mittels des Schalters als Eingangswert an die Linearisierungsschaltung angelegt werden.

Zur Anwendung des erfindungsgemäßen Verfahrens könnte eine Schaltung zur Linearisierung gemäß Patentanspruch 42 verwendet werden. Bei der Schaltung ist besonders vorteilhaft, dass eine einfache Eingabe von Soll-Eingangswerten und den zugehörigen Soll-Ausgangswerten in die Ablaufsteuerung ermöglicht ist.

Im Hinblick auf eine besonders kostengünstige Ausgestaltung könnte die Linearisierungsschaltung als Analogschaltung ausgeführt sein. Die Verwendung von analogen Bauelementen ist gegenüber digitalen Bauelementen bei gleich guter Auflösung und Genauigkeit sowie gleicher hoher Verarbeitungsgeschwindigkeit sehr viel kostengünstiger.

Im Rahmen einer besonders einfachen Ausgestaltung könnte die Ablaufsteuerung einen Mikroprozessor und/oder einen Speicher und/oder eine Eingabeeinheit und/oder Ausgabeeinheit umfassen. Dabei könnte es in besonders vorteilhafter Weise sich um einen handelsüblichen Computer handeln. Als Eingabeeinheit könnte eine Tastatur, eine Maus oder dergleichen dienen, aber auch ein Touch-Screen. Die Ausgabeeinheit könnte in besonders einfacher Weise ein Display oder Monitor oder dergleichen sein.

In einer besonders vorteilhaften Ausgestaltung könnte der Speicher als nichtflüchtiger Speicher ausgestaltet sein. Durch die Verwendung eines nichtflüchtigen Speichers könnten sämtliche Einstellungen sowie die verschiedenen zur Linearisierung verwendeten Eingangs- bzw. Ausgangswerte auch beim Ausschalten oder Ausfallen der Betriebsspannung beibehalten werden. Dies würde die Schaltung besonders robust und sehr universell einsetzbar machen.

Hinsichtlich einer besonders einfachen Ausgestaltung könnte eine Analogisierung von einem von der Ablaufsteuerung ausgegebenen Soll-Eingangswert mittels eines D/A-Wandlers erfolgen. Dieser D/A-Wandler könnte hierbei hochauflösend, müsste aber nicht besonders stabil sein. Auch sind keine besonderen Erfordernisse an die Schnelligkeit der Verarbeitungsgeschwindigkeit des D/A-Wandlers zu stellen. Der D/A-Wandler ermöglicht die Ermittlung der Soll-Eingangswerte in einem iterativen Vergleich, nämlich dahingehend, dass der Soll-Eingangswert solange durch die Ablaufsteuerung dem Ist-Eingangswert angenähert wird, bis keine Verbesserung mehr möglich ist, d. h. alle möglichen und erforderlichen Bits gesetzt sind. Der entsprechende Digitalwert wird dann in dem Speicher abgelegt und kann bei Aufruf die entsprechende Analogspannung wieder ausgeben werden.

Im Rahmen einer besonders kostengünstigen Ausgestaltung könnte eine Analogisierung von einem von der Ablaufsteuerung ausgegebenen Soll-Eingangswert mittels mindestens einer einstellbaren Signalquelle erfolgen. Hierdurch könnte der hochauflösende und damit teuere D/A-Wandler durch preisgünstigerer Bauelemente gesetzt werden.

In einer besonders einfachen Ausgestaltung könnten die einstellbaren Signalquellen mindestens eine Referenzsignalquelle und/oder mindestens ein vorzugsweise digital ansteuerbares Potentiometer umfassen. Hierdurch wäre wiederum wie obig beschrieben eine A/D-Wandlung des Ausgangssignals des Bauteils ermöglicht. Dies wäre nämlich dadurch möglich, dass das Ausgangssignal, das dem Ist-Eingangswert und dem Eingangswert der Linearisierungsschaltung entspricht, am Eingang eines vergleichenden Bauelements, beispielsweise eines Komparators, anliegt. Am anderen Eingang des vergleichenden Bauelements würde dann das Ausgangssignal der einstellbaren Signalquelle anliegen, das dem Soll-Eingangswert entspricht. Sind mehr als ein digital ansteuerbares Potentiometer vorgesehen, so könnten die Ausgangsspannungen der Potentiometer mittels eines Summierers addiert werden. Das Ausgangssignal dieses Summierers entspricht dann dem Soll-Eingangswert und würde am anderen Eingang des Komparators angelegen werden. Die Auswertung des Ausgangssignals des vergleichenden Bauelements würde einen Abgleich der Summenspannung durch Einstellung der Potentiometer mittels der Ablaufsteuerung ermöglichen. Der dem Ist-Eingangswert entsprechende Digitalwert könnte im Speicher abgelegt und bei Bedarf könnte die entsprechende Analogspannung wieder ausgegeben werden. Eine A/D-Wandlung des analog vorliegenden Ist-Eingangswerts wäre somit ermöglicht.

Hinsichtlich einer besonders einfachen Linearisierung könnten zum Abgleich der Linearisierungsschaltung Abgleichsmittel angeordnet sein. Die Ansteuerung der Abgleichsmittel könnte im besonders einfacher Weise mittels der Ablaufsteuerung erfolgen.

Im Rahmen einer abermals besonders kostengünstigen Ausgestaltung könnten die Abgleichsmittel mindestens ein insbesondere digital ansteuerbares Potentiometer umfassen. Die Abgleichsmittel könnten in besonders vorteilhafter Weise mindestens ein digital ansteuerbares Potentiometer zum Abgleich des Nullpunkts und/oder mindestens ein digital ansteuerbares Potentiometer zum Abgleich der Linearität und/oder mindestens ein digital ansteuerbares Potentiometer und/oder einen Verstärker zum Abgleich der Steigung der linearisierten Kennlinie umfassen.

Zum Abgleich eines von der Ablaufsteuerung ausgegebenen Soll-Ausgangswerts mit dem Ist-Ausgangswert der Linearisierungsschaltung könnte eine Analogisierung des Soll-Ausgangswerts mittels eines D/A-Wandlers erfolgen. Alternativ hierzu könnte zum Abgleich eines Soll-Ausgangswerts mit dem Ist-Ausgangswert der Linearisierungsschaltung die Einstellung des Soll-Ausgangswerts allerdings auch mittels fixer Referenzsignalquellen erfolgen. Insbesondere könnten drei fixe Referenzsignalquellen vorgesehen sein, die über einen mittels der Ablaufsteuerung ansteuerbaren Schalter wahlweise ausgegeben werden können.

Im Rahmen einer besonders einfachen Linearisierung könnte der Abgleich des von der Ablaufsteuerung ausgegebenen Soll-Ausgangswerts mit dem Ist-Ausgangswert der Linearisierungsschaltung mittels eines vergleichenden Bauteils, vorzugsweise eines Komparators, erfolgen. Das Ausgangssignal des Komparators könnte dann durch die Ablaufsteuerung ausgewertet werden und aufgrund des Ausgangssignals könnten die digitalen Potentiometer gemäß dem obig beschriebenen Verfahren zum Abgleich der Linearisierungsschaltung eingestellt werden.

In besonders vorteilhafter Weise könnte ein Schalter, insbesondere ein Wechsler oder ein Multiplexer oder dergleichen, zum wahlweise anlegen der von der Ablaufsteuerung ausgegebenen Soll-Ausgangswerte und des vom Bauteil ausgegebenen Ausgangssignals angeordnet sein. Das vom Bauteil ausgegebene Ausgangssignal entspricht hierbei dem Ist-Eingangswert.

Es gibt nun verschiedene Möglichkeiten, die Lehre der vorliegenden Erfindung in vorteilhafter Weise auszugestalten und weiterzubilden. Dazu ist einerseits auf die dem Patentanspruch 1 und dem nebengeordneten Patentanspruch 42 nachgeordneten Patentansprüche und andererseits auf die nachfolgende Erläuterung bevorzugter Ausführungsbeispiele eines erfindungsgemäßen Verfahrens und einer erfindungsgemäßen Schaltung zur Linearisierung von nichtlinearen Kennlinien anhand der Zeichnung zu verweisen. In Verbindung mit der Erläuterung der bevorzugten Ausführungsbeispiele des erfindungsgemäßen Verfahrens und der erfindungsgemäßen Schaltung anhand der Zeichnung werden auch im Allgemeinen bevorzugte Ausgestaltungen und Weiterbildungen der Lehre erläutert. In der Zeichnung zeigt
- Fig. 1: in einer schematischen Darstellung, ein Ausführungsbeispiel einer erfindungsgemäßen Schaltung zur Linearisierung von nichtlinearen Kennlinien zur Verwendung mit einem erfindungsgemäßen Verfahren,
- Fig. 2: in einer schematischen Darstellung, ein weiteres Ausführungsbeispiel einer erfindungsgemäßen Schaltung zur Verwendung mit einem erfindungsgemäßen Verfahren und
- Fig. 3: in einer schematischen Darstellung, ein weiteres Ausführungsbeispiel eines Teils einer erfindungsgemäßen Schaltung zur Verwendung mit einem erfindungsgemäßen Verfahren.

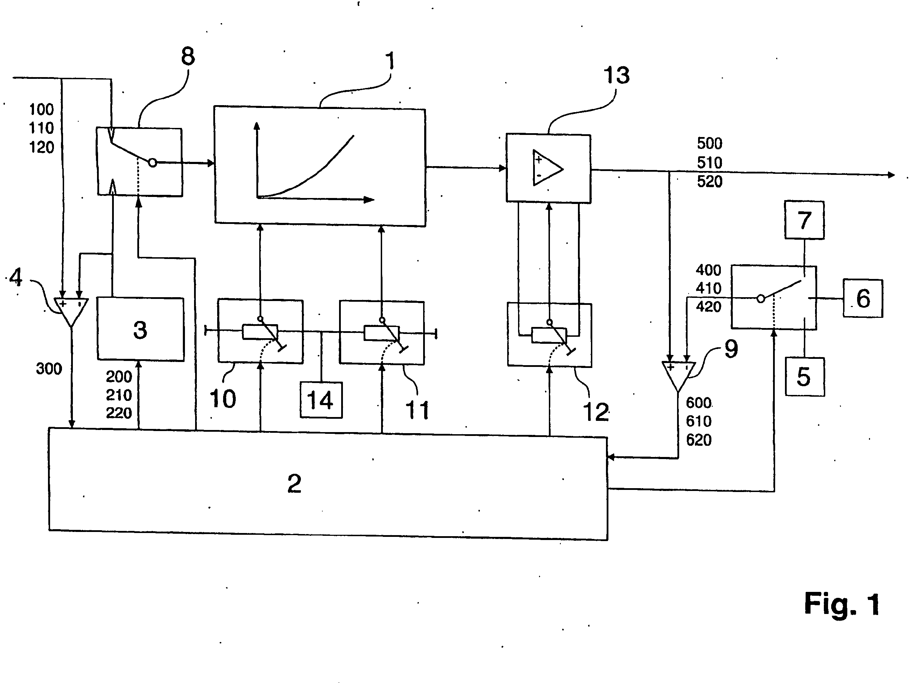

In Fig.1 ist eine Schaltung bzw. Schaltungsanordnung zur Verwendung mit einem Verfahren zur Linearisierung von nichtlinearen Kennlinien mit einer Linearisierungsschaltung 1 gezeigt, wobei die Kennlinie die Beziehung zwischen einem Eingangssignal und einem Ausgangssignal eines - hier nicht dargestellten - Bauteils darstellt, das als Sensor ausgestaltet ist. In diesem Ausführungsbeispiel handelt es sich bei dem Sensor um einen Wegmesssensor, der als Ausgangssignal eine elektrische Spannung liefert, die abhängig von einem physikalischen gemessenen Abstand ist.

Das Einstellen der Linearisierungsschaltung 1 erfolgt in erfindungsgemäßer Weise mittels einer Ablaufsteuerung 2. Die Ablaufsteuerung 2 erfaßt drei Ausgangssignale, die dem Ist-Eingangswert der Linearisierungsschaltung 100, 110 und 120 entsprechen. Das Ausgangssignal bzw. der Ist-Eingangswert 100 entspricht dabei dem kleinsten Messabstand, wenn der Sensor dem Messobjekt am nächsten ist, der Ist-Eingangswert 110 entspricht dem mittleren Messabstand und der Ist-Eingangswert 120 entspricht einem maximalen Messabstand. Mittels der Ablaufsteuerung 2 sowie eines D/A-Wandlers 3 wird ein Soll-Eingangswert 200 von der Ablaufsteuerung 2 vorgegeben und analogisiert. Dies dient zur Digitalisierung der Ist-Eingangswerte 100, 110, 120 in derart, dass die entsprechenden Soll-Eingangswerte 200, 210, 220 ebenso wie die Ist-Eingangswerte 100, 110, 120 an ein vergleichendes Bauelement, das in diesem Ausführungsbeispiel als Komparator 4 ausgestaltet ist, angelegt wird und das Ausgangssignal 300 des Komparators 4 von der Ablaufsteuerung 2 dazu verwendet wird, die Soll-Eingangswerte 200, 210, 220 solange iterativ abzugleichen, bis eine vorgegebene Abweichung zwischen den Ist-Eingangswerten 100, 110, 120 und den Soll-Eingangswerten 200, 210, 220 unterschritten wird. Die Soll-Eingangswerte 200, 210, 220 entsprechen hierbei dem Anfangspunkt, dem Mittelpunkt und dem Endpunkt der linearisierten Kennlinie. Die den jeweiligen Ist-Eingangswerte 100, 110, 120 entsprechenden digitalen Werte werden in der Ablaufsteuerung 2 in einem Speicher abgelegt und bei Aufruf kann die entsprechende Analogspannung wieder ausgegeben werden. Somit ist eine besonders einfache A/D-Wandlung der Ist-Eingangswerte 100, 110, 120 und somit des Ausgangssignals des Sensors erreicht.

Zu den Ist-Eingangswerten 100, 110, 120 werden mittels der Ablaufsteuerung 2 Soll-Ausgangswerte 400, 410, 420 erfaßt und gespeichert. Diese Soll-Ausgangswerte 400, 410, 420 werden im Ausführungsbeispiel der Fig. 1 mittels drei Referenzsignalquellen 5, 6, 7 eingestellt. Die Referenzsignalquellen 5, 6, 7 liefern hierbei drei feste Referenzspannungen, nämlich 0 Volt, 5 Volt sowie 10 Volt.

Zum Abgleich der Linearisierungsschaltung 1 werden nunmehr jeweils die von der Ablaufsteuerung ausgegebene Soll-Eingangswerte 200, 210, 220 mittels des D/A-Wandlers 3 analogisiert. Die von der Ablaufsteuerung ausgegebenen analogisierten Soll-Eingangswerte 200, 210, 220 werden über einen Schalter 8 an den Eingang der Linearisierungsschaltung 1 angelegt. Der Schalter 8 ist hierbei von der Ablaufsteuerung 2 ansteuerbar. Die Linearisierungsschaltung 1 gibt daraufhin Ist-Ausgangswerte 500, 510, 520 aus.

Mittels eines vergleichenden Bauelements, dass in diesem Ausführungsbeispiel als Komparator 9 ausgestaltet ist, werden die auf die Soll-Eingangswerte 200, 210, 220 von der Linearisierungsschaltung 1 ausgegebenen Ist-Ausgangswerte 500, 510, 520 mit den Soll-Ausgangswerten 400, 410, 420 verglichen, wobei die Ausgangssignale 600, 610, 620 des Komparators 9 durch die Ablaufsteuerung 2 ausgewertet werden. Aufgrund der Abweichung zwischen den Ist-Ausgangswerten 500, 510, 520 und den Soll-Ausgangswerten 400, 410, 420 stellt die Ablaufsteuerung 2 nunmehr Abgleichsmittel 10, 11, 12, 13 ein, mit denen die Linearisierungsschaltung 1 abgeglichen wird.

In diesem speziellen Ausführungsbeispiel dient das Abgleichsmittel 10 zum Abgleich des Nullpunkts der linearisierten Kennlinie sowie das weitere Abgleichsmittel 11 zum Abgleich der Liniarität der linearisierten Kennlinie und die Abgleichsmittel 12, 13 zum Abgleich der Steigung der linearisierten Kennlinie. Bei den Abgleichsmitteln 10, 11, 12 handelt es sich in diesem Ausführungsbeispiel um digital ansteuerbare Potentiometer, die mittels der Ablaufsteuerung 2 angesteuert werden. Das Abgleichsmittel 12, 13 zum Abgleich der Steigung der Kennlinie umfaßt hierbei zusätzlich einen Verstärker 13.

Die Ablaufsteuerung 2 führt mittels der Abgleichsmittel 10, 11, 12, 13 für jedes Soll-Eingangs-/Soll-Ausgangswertepaar 200, 400, 210, 410, 220, 420 einen Abgleich der Linearisierungsschaltung 1 solange durch, bis eine vorgegebene Abweichung zwischen den Ist-Ausgangswerten 500, 510, 520 und den Soll-Ausgangswerten 400, 410, 420 unterschritten wird. Zur Einstellung der Linearisierungsschaltung 1 mittels der Abgleichsmittel 10, 11, 12, 13 ist eine Referenzsignalquelle vorgesehen, die in diesem Ausführungsbeispiel als Spannungsquelle 14 ausgestaltet ist.

Im Konkreten wird nun der Soll-Eingangswert 200, der mittels des obig beschriebenen Verfahrens auf den Ist-Eingangswert 100 abgeglichen und durch den D/A-Wandler 3 analogisiert wird, über den Schalter 8 an die Linearisierungsschaltung 1 angelegt. Im Wesentlichen gleichzeitig wird der entsprechende Soll-Ausgangswert 400 an den Komparator 9 angelegt. Das Ausgangssignal 600 des Komparators 9 wird nun mittels der Ablaufsteuerung 2 ausgewertet und das Potentiometer 10 mittels Digitalimpulsen von der Ablaufsteuerung 2 derart eingestellt, dass der Ist-Ausgangswert 500 im Wesentlichen gleich dem Soll-Ausgangswert 400 ist, also das Ausgangssignal 600 des Komparators 9 einen vorgegebenen Wert für eine zulässige Toleranz unterschreitet. Das Einstellen des Potentiometers 10 erfolgt hierbei iterativ.

Sobald das Ausgangssignal 600 des Komparators 9 einen vorgegebenen Wert, unterschreitet, wird ein weiterer von der Ablaufsteuerung 2 ausgegebener und durch den D/A-Wandler 3 analogisierter Soll-Eingangswert 210 an die Linearisierungsschaltung 1 angelegt. Der Soll-Eingangswert 210 ist wiederum mittels des obig beschriebenen Verfahrens auf den Ist-Eingangswert 110 abgeglichen und entspricht somit somit im Wesentlichen dem Ist-Eingangswert 110. Im Wesentlichen gleichzeitig wird der zugehörige von der Ablaufsteuerung 2 ausgegebene Soll-Ausgangswert 410 an den Komparator 9 angelegt. Zudem liegt der Ist-Ausgangswert 510 der Linearisierungsschaltung des weiteren Soll-Eingangs-/Soll-Ausgangswertepaars 210, 410 am Komparator 9 an. Wiederum wird das Ausgangssignal 610 des Komparators 9 durch die Ablaufsteuerung 2 ausgewertet.

Aufgrund der Auswertung des Ausgangssignals 610 wird das Potentiometer 12 in Verbindung mit dem Verstärker 13 zur Einstellung der Steigung der linearisierten Kennlinie von der Ablaufsteuerung solange iterativ abgeglichen, dass der Ist-Ausgangswert 510 im Wesentlichen dem Soll-Ausgangswert 410 entspricht. Dies wird anhand des Ausgangssignals 610 des Komparators 9 durch die Ablaufsteuerung 2 erfaßt.

Nunmehr wird ein weiterer von der Ablaufsteuerung 2 ausgegebener und mittels des A/D-Wandlers 3 analogisierter Soll-Eingangswert 220 an die Linearisierungsschaltung 1 angelegt. Im Wesentlichen gleichzeitig wird der zugehörige von der Ablaufsteuerung 2 ausgegebene Soll-Ausgangswert 420 an den Komparator 9 angelegt. Der zum weiteren Soll-Eingangs-/Soll-Ausgangswertepaars 220, 420 gehörige Ist-Ausgangswert 520 wird ebenfalls an den Komparator 9 angelegt. Das Ausgangssignal 620 des Komparators 9 wird durch die Ablaufsteuerung 2 ausgewertet und dementsprechend das Potentiometer 11 zur Einstellung der Liniarität der Kennlinie derart und solange iterativ eingestellt, bis zulässige Toleranz unterschritten wird.

Die Einstellung der Potentiometer 10, 11, 12 sowie des Verstärkers 13 wird für alle Soll-Eingangs-/Soll-Ausgangswertepaare 200, 400, 210, 410, 220, 420 solange wiederholt, bis für alle Soll-Ausgangswerte 400, 410, 420 eine vorgegebene Abweichung zwischen dem Ist-Ausgangswert 500, 510, 520 und dem Soll-Ausgangswert 400, 410, 420 unterschritten wird.

Dieser Vorgang zur Linearisierung wird nunmehr für verschiedene Messmaterialien wiederholt und die einzelnen unterschiedlichen linearisierten Kennlinien werden in der Ablaufsteuerung 2 gespeichert.

Zum Beginn der Messung wird nun nach der Linearisierung der Kennlinie das Ausgangssignal 100, 110, 120 des Sensors mittels des von der Ablaufsteuerung 2 gesteuerten Schalters 8 als Eingangswert an die Linearisierungsschaltung angelegt. Eine laufende Messung ist nunmehr möglich, wobei die Ausgangssignale des Sensors mittels der linearisierten Kennlinie linearisiert werden.

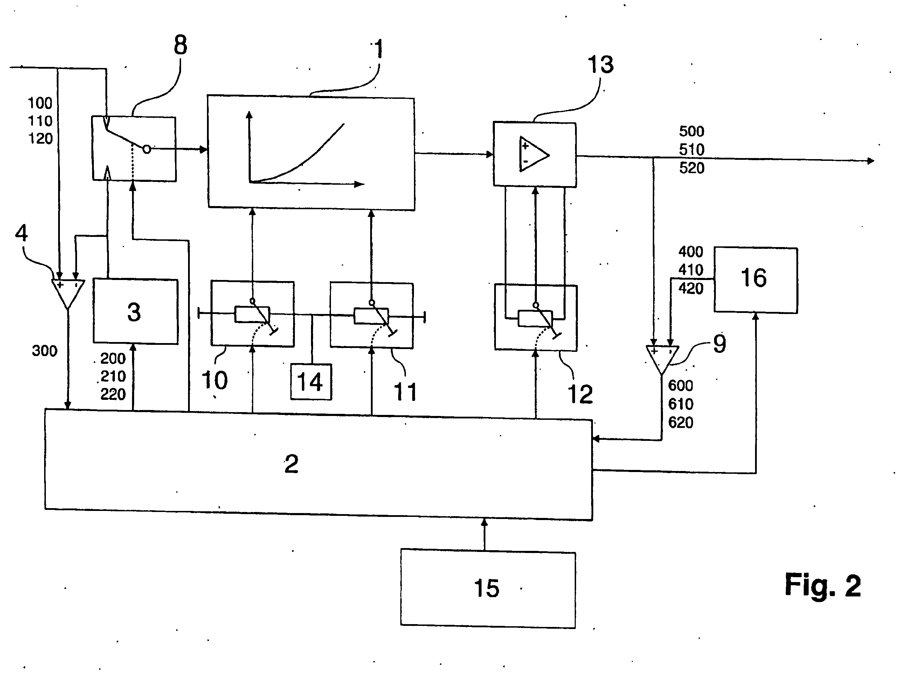

Fig. 2 zeigt ein weiteres Ausführungsbeispiel einer erfindungsgemäßen Vorrichtung zur Verwendung mit dem erfindungsgemäßen Verfahren. In diesem speziellen Ausführungsbeispiel sind der Messbereichsanfang, die Messbereichsmitte und das Messbereichsende nicht exakt einstellbar, sondern können nur angenähert werden, es sind jedoch die tatsächlichen Werte bekannt und somit stehen auch die entsprechenden Soll-Ausgangswerte 400, 410, 420 fest. Diese Soll-Ausgangswerte 400, 410, 420 werden über eine Tastatur 15 in die Ablaufsteuerung 2 eingegeben, wobei die Soll-Ausgangswerte 400, 410, 420 mittels eines D/A-Wandiers 16 analogisiert werden. Der D/A-Wandler 16 weist eine geringe Auflösung und Genauigkeit auf, nämlich ca. 13 bis 14 Bit. Der Abgleich der Linearisierungsschaltung 1 erfolgt wie bereits obig beschrieben.

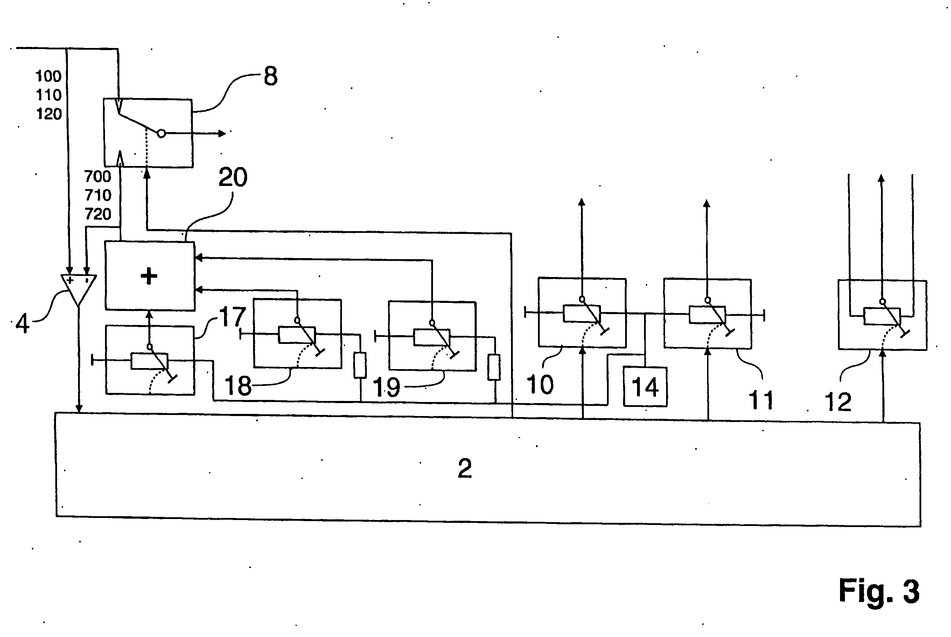

Ein weiteres Ausführungsbeispiel einer Schaltung zur Linearisierung von Kennlinien zeigt Fig. 3. In diesem speziellen Ausführungsbeispiel erfolgt die Analogisierung der Soll-Eingangswerte 200, 210, 220 mittels einstellbarer Signalquellen. Die Signalquellen umfassen hierbei eine Referenzspannung 14 und drei digital ansteuerbare Potentiometer 17, 18, 19. Die Potentiometer 17, 18, 19 sind mittels der Ablaufsteuerung 2 in äquidistanten Stufen einstellbar und die Ausgangssignale der Potentiometer 17, 18, 19 werden mittels eines Summierers 20 addiert. Die Analogisierung erfolgt nun in derart, dass die Potentiometer 17, 18, 19 der Reihe nach so eingestellt werden, dass die Summenspannung 700, 710, 720 am Ausgang des Summierers 20 dem Ist-Eingangswert 100, 110, 120 entspricht. Zunächst erfolgt dabei ein Grobabgleich mittels des Potentiometers 17, dann mit ein Feinabgleich mittels des Potentiometers 18 und schließlich ein Feinstabgleich mittels des Potentiometers 19.

Dabei entspricht der Einstellbereich des Potentiometers 18 einer Stufe des Potentiometers 17 und der Einstellbereich des Potentiometers 19 einer Stufe des Einstellbereichs des Potentiometers 18. In diesem speziellen Ausführungsbeispiel wurden digitale Potentiometer mit 6 Bit vorgesehen, d. h. mit 64 wählbaren äquidistanten Stufen. Demnach liefert das Potentiometer 17 eine Spannung von 0 bis 10 Volt in 64 Stufen ä 156,25 mV. Das Potentiometer 18 liefert eine Spannung von 0 bis 157 mV in 64 Stufen ä 2,45 mV und das Potentiometer 19 liefert eine Spannung von 0 bis 2,45 mV in 64 Stufen, d.h. 0,0383 mV. Dies entspricht bei dem gegebenen 10-Voltbereich einer Auflösung von 18 Bit, d. h. 1 : 260.000.

Der abzuspeichernde Digitalwert des Ist-Eingangswert 100, 110, 120 ergibt sich aus den einzelnen Einstellungen der Potentiometer 17, 18, 19, d. h. 3 x 6 Bit. Durch die Analogisierung des Soll-Eingangswerts in Verbindung mit dem Abgleich mit dem Ist-Eingangswert 100, 110, 120 erfolgt somit eine Digitalisierung des Ist-Eingangswerts 100, 110, 120.

Hinsichtlich weiterer Details wird zur Vermeidung von Wiederholungen auf den allgemeinen Teil der Beschreibung sowie auf die beigefügten Patentansprüche verwiesen.

Schließlich sei ausdrücklich darauf hingewiesen, dass die voranstehend beschriebenen Ausführungsbeispiele lediglich zur Erörterung der beanspruchten Lehre dienen, diese jedoch nicht auf die Ausführungsbeispiele einschränken.

## Patentansprüche

1. Verfahren zur Linearisierung von nichtlinearen Kennlinien mit einer analogen Linearisierungsschaltung (1), wobei die Kennlinie die Beziehung zwischen Eingangssignalen und Ausgangssignalen eines Sensors darstellt, wobei ein Ausgangssignal (100, 110, 120) jeweils einem Eingangssignal zugeordnet ist, und wobei das Einstellen der Linearisierungsschaltung (1) automatisiert mittels einer Ablaufsteuerung (2) erfolgt,
**dadurch gekennzeichnet, dass** zum Einstellen der Linearisierungsschaltung (1) durch die Ablaufsteuerung (2) mindestens ein Soll-Eingangswert (200, 210, 220) ausgegeben und der Linearisierungsschaltung (1) zugeführt wird, dass die Linerarisierungsschaltung (1) bei Beaufschlagung mit einem Soll-Eingangswert (200, 210, 220) einen Ist-Ausgangswert (500, 510, 520) ausgibt, der mit einem Soll-Ausgangswert (400, 410, 420) verglichen wird, und dass basierend auf die Vergleichsergebnisse eine Einstellung der Linearisierungsschaltung (1) vorgenommen wird.

2. Verfahren nach Anspruch 1, **dadurch gekennzeichnet, dass** mindestens ein Ausgangssignal (100, 110, 120) als Ist-Eingangswert mittels der Ablaufsteuerung (2) erfasst und gespeichert wird.

3. Verfahren nach Anspruch 1 oder 2, **dadurch gekennzeichnet, dass** mindestens ein Soll-Eingangswert (200, 210, 220) über eine Eingabeeinheit (15) in die Ablaufsteuerung (2) eingegeben wird, wobei der Soll-Eingangswert (200, 210, 220) mittels eines D/A-Wandlers (3) oder mittels mindestens einer einstellbaren Signalquelle analogisiert werden kann.

4. Verfahren nach Anspruch 3, **dadurch gekennzeichnet, dass** die Signalquelle durch mindestens eine Referenzspannung (14) oder mindestens einen digital ansteuerbaren Potentiometer (17, 18, 19) gebildet wird, wobei das Potentiometer (17, 18, 19) mittels der Ablaufsteuerung (2) in äquidistanten Stufen eingestellt wird, wobei der Soll-Eingangswert (200, 210, 220) mittels drei digital ansteuerbarer Potentiometer (17, 18, 19) eingestellt wird, wobei die Ausgangssignale der Potentiometer (17, 18, 19) mittels eines Summierers (20) addiert werden und wobei die Einstellungen der Potentiometer (17, 18, 19) in Verbindung mit dem zugehörigen Soll-Eingangswert (200, 210, 220) und einen Soll-Ausgangswert (400, 410, 420) gespeichert werden.

5. Verfahren nach Anspruch 3 oder 4, **dadurch gekennzeichnet, dass** die Ist-Eingangswerte (100, 110, 120) und die Soll-Eingangswerte (200, 210, 220) an ein vergleichendes Bauelement (4) anlegt werden, wobei der Soll-Eingangswert (200, 210, 220) mittels des vergleichenden Bauelements mit dem Ist-Eingangswert (100, 110, 120) verglichen werden kann und wobei die Ablaufsteuerung (2) solange den Soll-Eingangswert (200, 210, 220) iterativ abgleicht, bis eine vorgegebene Abweichung zwischen dem Ist-Eingangswert (100, 110, 120) und dem Soll-Eingangswert (200, 210, 220) unterschritten werden kann und wobei die Soll-Eingangswerte (200, 210, 220) als Anfangspunkt (200), als Mittelpunkt (210) oder als Endpunkt (220) der linearisierten Kennlinie gewählt werden können oder wobei die Soll-Eingangswerte (200, 210, 220) aus einem Teilbereich von Eingangssignalen der nichtlinearen Kennlinie gewählt werden können und wobei die von der Ablaufsteuerung (2) ausgegebenen Soll-Eingangswerte (200, 210, 220) über einen Schalter (8) an den Eingang der Linearisierungsschaltung (1) anlegt werden.

6. Verfahren nach einem der Ansprüche 2 bis 5, **dadurch gekennzeichnet, dass** mindestens ein zum Ist-Eingangswert (100, 110, 120) zugehöriger Soll-Ausgangswert (400, 410, 420) mittels der Ablaufsteuerung (2) erfasst und gespeichert wird, wobei mindestens ein Soll-Ausgangswert (400, 410, 420) mittels Referenzsignalquellen (5, 6, 7) eingestellt werden kann, und wobei die Soll-Eingangswerte (200, 210, 220) mittels des D/A-Wandlers (3) analogisiert werden können oder wobei mindestens ein zum Ist-Eingangswert (100, 110, 120) zugehöriger Soll-Ausgangswert (400, 410, 420) über eine Eingabeeinheit (15) in die Ablaufsteuerung (2) eingegeben werden kann.

7. Verfahren nach Anspruch 6, **dadurch gekennzeichnet, dass** mittels eines vergleichenden Bauelements (9) die auf die Soll-Eingangswerte (200, 210, 220) von der Linearisierungsschaltung (1) ausgegebenen Ist-Ausgangswerte (500, 510, 520) mit den Soll-Ausgangswerten (400, 410, 420) verglichen wird, wobei das Ausgangssignal (600, 610, 620) des vergleichenden Bauelements (9) durch die Ablaufsteuerung (2) ausgewertet werden kann.

8. Verfahren nach einem der Ansprüche 1 bis 7, **dadurch gekennzeichnet, dass** mittels der Ablaufsteuerung (2) mindestens ein Abgleichsmittel (10,11,12,13) eingestellt wird, wobei mindestens ein Abgleichsmittel (10) zum Abgleich des Nullpunkts oder mindestens ein Abgleichsmittel (11) zum Abgleich der Linearität oder mindestens ein Abgleichsmittel (12, 13) zum Abgleich der Steigung der linearisierten Kennlinie dienen kann und wobei die Ablaufsteuerung (2) die Abgleichsmittel (10, 11, 12) mit Digitalimpulsen ansteuert und wobei die Ablaufsteuerung (2) mittels der Abgleichsmittel (10, 11, 12, 13) für jedes Soll-Eingangs-/Soll-Ausgangswertepaar einen Abgleich der Linearisierungsschaltung (1) solange durchführt, bis eine vorgegebene Abweichung zwischen dem Ist-Ausgangswert (500, 510, 520) und dem Soll-Ausgangswert (400, 410, 420) unterschritten werden kann oder wobei das Abgleichsmittel (10) zur Einstellung des Nullpunkts der linearisierten Kennlinie derart eingestellt wird, dass der Ist-Ausgangswert (500, 510, 520) im Wesentlichen gleich dem Soll-Ausgangswert (400, 410, 420) sein kann und wobei ein weiterer von der Ablaufsteuerung (2) ausgegebener Soll-Eingangswert (210) an die Linearisierungsschaltung (1) angelegt werden kann.

9. Verfahren nach Anspruch 8, **dadurch gekennzeichnet, dass** der zugehörige von der Ablaufsteuerung (2) ausgegebene Soll-Ausgangswert (410) an das vergleichende Bauelement (9) angelegt wird, wobei der Ist-Ausgangswert (510) der Linearisierungsschaltung des weiteren Soll-Eingangs-/Soll-Ausgangswertepaars (210, 410) an das vergleichende Bauelement (9) angelegt wird, wobei das Ausgangssignal (610) des vergleichenden Bauelements (9) durch die Ablaufsteuerung (2) ausgewertet werden kann oder wobei das Abgleichsmittel (12, 13) zur Einstellung der Steigung der linearisierten Kennlinie derart eingestellt wird, dass der Ist-Ausgangswert (510) im Wesentlichen gleich dem Soll-Ausgangswert sein kann (410).

10. Verfahren nach Anspruch 8 oder 9, **dadurch gekennzeichnet, dass** ein weiterer von der Ablaufsteuerung (2) ausgegebener Soll-Eingangswert (220) an die Linearisierungsschaltung (1) angelegt wird, wobei der zugehörige von der Ablaufsteuerung (2) ausgegebene Soll-Ausgangswert (420) an das vergleichende Bauelement (9) angelegt werden kann und wobei der Ist-Ausgangswert (520) des weiteren Soll-Eingangs-/Soll-Ausgangswertepaars (220, 240) an das vergleichende Bauelement (9) angelegt werden kann, und wobei das Ausgangssignal (620) des vergleichenden Bauelements (9) durch die Ablaufsteuerung (2) ausgewertet werden kann oder wobei das Abgleichsmittel (11) zur Einstellung der Linearität der Kennlinie derart eingestellt wird, dass der Ist-Ausgangswert (520) im Wesentlichen gleich dem Soll-Ausgangswert (420) sein kann.

11. Verfahren nach einem der Ansprüche 8 bis 10, **dadurch gekennzeichnet, dass** der Abgleich der Abgleichsmittel (10, 11, 12, 13) für die Soll-Eingangs-/Soll-Ausgangswertepaare solange wiederholt wird, bis für alle Soll-Ausgangswerte (400, 410, 420) eine vorgegebene Abweichung zwischen dem Ist-Ausgangswert (500, 510,520) und dem Soll-Ausgangswert (400, 410, 420) unterschritten wird.

12. Verfahren nach einem der Ansprüche 1 bis 11, **dadurch gekennzeichnet, dass** in der Ablaufsteuerung (2) unterschiedliche linearisierte Kennlinien gespeichert werden und dass nach der Linearisierung der Kennlinie das Ausgangssignal (100, 110, 120) des Sensors mittels des Schalters (8) als Eingangswert an die Linearisierungsschaltung (1) angelegt wird.

## Claims

1. Method for linearizing non-linear curves with an analogue linearization circuit (1), wherein the curve represents the relationship between input signals and output signals of a sensor, wherein an output signal (100, 110, 120) is respectively associated with an input signal, and wherein the adjustment of the linearization circuit (1) occurs in an automated way by means of a sequence controller (2),
**characterised in that**, for adjusting the linearization circuit (1), at least one reference input value (200, 210, 220) is output by the sequence controller (2) and supplied to the linearization circuit (1), the linearization circuit (1), when acted upon by a reference input value (200, 210, 220), outputs an actual output valve (500, 510, 520) which is compared with a reference output value (400, 410, 420), and, based on the results of the comparison, adjustment of the linearization circuit (1) is performed.

2. Method according to claim 1, **characterised in that** at least one output signal (100, 110, 120) is acquired and stored as the actual input value by means of the sequence controller (2).

3. Method according to claim 1 or 2, **characterised in that** at least one reference input value (200, 210, 220) is entered into the sequence controller (2) via an input unit (15), it being possible for the reference input value (200, 210, 220) to be analogized by means of a D/A converter (3) or by means of at least one adjustable source of signals.

4. Method according to claim 3, **characterised in that** the source of signals is formed by at least one reference voltage (14) or at least one digitally activatable potentiometer (17, 18, 19), wherein the potentiometer (17, 18, 19) is adjusted in equidistant steps by means of the sequence controller (2), wherein the reference input value (200, 210, 220) is adjusted by means of three digitally activatable potentiometers (17, 18, 19), wherein the output signals of the potentiometers (17, 18, 19) are added by means of a summator (20), and wherein the settings of the potentiometers (17, 18, 19) are stored in combination with the associated reference input value (200, 210, 220) and a reference output value (400, 410, 420).

5. Method according to claim 3 or 4, **characterised in that** the actual input values (100, 110, 120) and the reference input values (200, 210, 220) are applied to a comparing component (4), wherein the reference input value (200, 210, 220) may be compared with the actual input value (100, 110, 120) by means of the comparing component and wherein the sequence controller (2) adjusts the reference input value (200, 210, 220) by iteration until a predetermined deviation between the actual input value (100, 110, 120) and the reference input value (200, 210, 220) may be undershot, and wherein the reference input values (200, 210, 220) may be selected as starting point (200), midpoint (210) or end point (220) of the linearized curve, or wherein the reference input values (200, 210, 220) may be selected from a subrange of input signals of the nonlinear curve, and wherein the reference input values (200, 210, 220) output by the sequence controller (2) are applied to the input of the linearization circuit (1) via a switch (8).

6. Method according to any one of claims 2 to 5, **characterised in that** at least one reference output value (400, 410, 420) associated with the actual input value (100, 110, 120) is acquired and stored by means of the sequence controller (2), wherein at least one reference output value (400, 410, 420) may be adjusted by means of reference signal sources (5, 6, 7), and wherein the reference input values (200, 210, 220) may be analogized by means of the D/A converter (3), or wherein at least one reference output value (400, 410, 420) associated with the actual input value (100, 110, 120) may be entered into the sequence controller (2) via an input unit (15).

7. Method according to claim 6, **characterised in that** by means of a comparing component (9) the actual output values (500, 510, 520) as supplied by the linearization circuit (1) in response to the reference input values (200, 210, 220) are compared with the reference output values (400, 410, 420), wherein the output signal (600, 610, 620) of the comparing component (9) may be evaluated by the sequence controller (2).

8. Method according to any one of claims 1 to 7, **characterised in that** at least one adjusting device (10, 11, 12, 13) is adjusted by means of the sequence controller (2), wherein at least one adjusting device (10) may be used for adjusting the zero point, or at least one adjusting device (11) may be used for adjusting the linearity, or at least one adjusting device (12, 13) may be used for adjusting the slope of the linearized curve, and wherein the sequence controller (2) activates the adjusting devices (10, 11, 12) with digital pulses, and wherein the sequence controller (2) performs an adjustment of the linearization circuit (1) by means of the adjusting devices (10, 11, 12, 13) for each pair of reference input/reference output values until a predetermined deviation between the actual output value (500, 510, 520) and the reference output value (400, 410, 420) can be undershot, or wherein the adjusting device (10) for adjusting the zero point of the linearized curve is adjusted such that the actual output value (500, 510, 520) may be substantially equal to the reference output value (400, 410, 420), and wherein a further reference input value (210) output by the sequence controller (2) may be applied to the linearization circuit (1).

9. Method according to claim 8, **characterised in that** the associated reference output value (410) output by the sequence controller (2) is applied to the comparing component (9), wherein the actual output value (510) of the linearization circuit of the further pair of reference input/reference output values (210, 410) is applied to the comparing component (9), wherein the output signal (610) of the comparing component (9) may be evaluated by the sequence controller (2), or wherein the adjusting device (12, 13) for adjusting the slope of the linearized curve is adjusted such that the actual output value (510) may be substantially equal to the reference output value (410).

10. Method according to claim 8 or 9, **characterised in that** a further reference input value (220) output by the sequence controller (2) is applied to the linearization circuit (1), wherein the associated reference output value (420) output by the sequence controller (2) may be applied to the comparing component (9), and wherein the actual output value (520) of the further pair of reference input/reference output values (220, 240) may be applied to the comparing component (9) and wherein the output signal (620) of the comparing component (9) may be evaluated by the sequence controller (2), or wherein the adjusting device (11) for adjusting the linearity of the curve is adjusted such that the actual output value (520) may be substantially equal to the reference output value (420).

11. Method according to any one of claims 8 to 10, **characterised in that** the adjustment of the adjusting devices (10, 11, 12, 13) is repeated for the pairs of reference input/reference output values until a predetermined deviation between the actual output value (500, 510, 520) and the reference output value (400, 410, 420) is undershot for all reference output values (400, 410, 420).

12. Method according to any one of claims 1 to 11, **characterised in that** different linearized curves are stored in the sequence controller (2), and **in that**, after linearization of the curve, the output signal (100, 110, 120) of the sensor is applied as input value to the linearization circuit (1) by means of the switch (8).

## Revendications

1. Procédé pour la linéarisation de lignes caractéristiques non linéaires par un circuit de linéarisation (1) analogique, la ligne caractéristique représentant la relation entre des signaux d'entrée et des signaux de sortie d'un capteur, un signal de sortie (100, 110, 120) étant adjoint respectivement à un signal d'entrée, et le réglage du circuit de linéarisation (1) ayant lieu de manière automatisée au moyen d'une commande séquentielle (2),
**caractérisé par le fait que**, pour le réglage du circuit de linéarisation (1) par la commande séquentielle (2), au moins une valeur d'entrée de consigne (200, 210, 220) est émise et envoyée au circuit de linéarisation (1), que le circuit de linéarisation (1) sort, lorsqu'il est soumis à une valeur d'entrée de consigne (200, 210, 220), une valeur de sortie effective (500, 510, 520) qui est comparée avec une valeur de sortie de consigne (400, 410, 420) et qu'un réglage du circuit de linéarisation (1) est entrepris en se basant sur les résultats de la comparaison.

2. Procédé selon la revendication 1,
**caractérisé par le fait qu'**au moins un signal de sortie (100, 110, 120) est saisi au moyen de la commande séquentielle (2) en tant que valeur d'entrée effective.

3. Procédé selon la revendication 1 ou 2,
**caractérisé par le fait qu'**au moins une valeur d'entrée de consigne (200, 210, 220) est entrée dans la commande séquentielle (2) au moyen d'une unité d'entrée (15), la valeur d'entrée de consigne (200, 210, 220) pouvant être rendue analogique au moyen d'un convertisseur N/A (3) ou au moyen d'au moins une source de signaux réglable.

4. Procédé selon la revendication 3,
**caractérisé par le fait que** la source de signaux est formée par au moins une tension de référence (14) ou au moins un potentiomètre (17, 18, 19) pouvant être commandé numériquement, le potentiomètre (17, 18, 19) étant réglé en étages équidistants au moyen de la commande séquentielle (2), la valeur d'entrée de consigne (200, 210, 220) étant réglée au moyen de trois potentiomètres (17, 18, 19) pouvant être commandés numériquement, les signaux de sortie des potentiomètres pouvant être additionnés au moyen d'un additionneur (20) et les réglages des potentiomètres (17, 18, 19) étant mémorisés en liaison avec la valeur d'entrée adjointe (200, 210, 220) et une valeur de sortie de consigne (400, 410, 420).

5. Procédé selon la revendication 3 ou 4,
**caractérisé par le fait que** les valeurs d'entrée effectives (100, 110, 120) et les valeurs d'entrée de consigne (200, 210, 220) sont appliquées à un composant (4) comparateur, la valeur d'entrée de consigne (200, 210, 220) pouvant être comparée avec la valeur d'entrée effective (100, 110, 120) au moyen du composant comparateur et la commande séquentielle (2) égalisant la valeur d'entrée de consigne (200, 210, 220) de manière itérative jusqu'à ce qu'une divergence prédéfinie entre la valeur d'entrée effective (100, 110, 120) et la valeur d'entrée de consigne (200, 210, 220) puisse ne pas être atteinte et les valeurs d'entrée de consigne (200, 210, 220) pouvant être choisies en tant que point de départ (200), en tant que point médian (210) ou en tant que point final (220) de la ligne caractéristique linéarisée ou les valeurs d'entrée de consigne (200, 210, 220) pouvant être choisies depuis une zone partielle de signaux d'entrée de la ligne caractéristique non linéaire et les valeurs d'entrée de consigne (200, 210, 220) sorties par la commande séquentielle (2) étant appliquées par l'intermédiaire d'un actionneur (8) à l'entrée du circuit de linéarisation (1).

6. Procédé selon l'une des revendications 2 à 5,
**caractérisé par le fait qu'**au moins une valeur de sortie de consigne (400, 410, 420) qui appartient à la valeur d'entrée effective (100, 110, 120) est saisie au moyen de la commande séquentielle (2) et mémorisée, au moins une valeur de sortie de consigne (400, 410, 420) pouvant être réglée au moyen de sources de signaux de référence (5, 6, 7) et les valeurs d'entrée de consigne (200, 210, 220) pouvant être rendues analogiques au moyen du convertisseur N/A (3) et au moins une valeur de sortie de consigne (400, 410, 420) appartenant à la valeur d'entrée effective (100, 110, 120) pouvant être entrée dans la commande séquentielle (2) par l'intermédiaire d'une unité d'entrée (15).

7. Procédé selon la revendication 6,
**caractérisé par le fait que** les valeurs de sortie effectives (500, 510, 520) sorties par le circuit de linéarisation (1) sur les valeurs d'entrée effectives (200, 210, 220) au moyen d'un composant (9) comparateur sont comparées aux valeurs de sortie de consigne (400, 410, 420), le signal de sortie (600, 610, 620) du composant (9) comparateur pouvant être évalué par la commande séquentielle (2).

8. Procédé selon l'une des revendications 1 à 7,
**caractérisé par le fait qu'**au moins un organe d'égalisation (10, 11, 12) est réglé au moyen de la commande séquentielle (2), un organe d'égalisation (10) pouvant servir pour l'égalisation du point zéro ou au moins un organe d'égalisation (11) pour l'égalisation de la linéarité ou au moins un organe d'égalisation (12, 13) pour l'égalisation de la croissance de la ligne caractéristique linéarisée et la commande séquentielle (2) commandant la commande séquentielle (2) au moyen d'impulsions numériques et la commande séquentielle effectuant au moyen des organes d'égalisation (10, 11, 12, 13), pour chaque paire de valeurs d'entrée de consigne/de sortie de consigne, une égalisation du circuit de linéarisation (1) jusqu'à ce qu'une divergence prédéfinie entre la valeur de sortie effective (500, 510, 520) et la valeur de sortie de consigne (400, 410, 420) puisse ne pas être atteinte et l'organe d'égalisation (10) pour le réglage du point zéro de la ligne caractéristique linéarisée étant réglé de telle manière que la valeur de sortie effective (500, 510, 520) puisse être pour l'essentiel égale à la valeur de sortie de consigne (400, 410, 420) et une autre valeur d'entrée de consigne (210) sortie par la commande séquentielle (2) pouvant être appliquée au circuit de linéarisation (1).

9. Procédé selon la revendication 8,
**caractérisé par le fait que** la valeur de sortie de consigne (410) sortie par la commande séquentielle (2) qui lui appartient est appliquée au composant (9) comparateur, la valeur de sortie effective (510) du circuit de linéarisation de l'autre paire de valeurs d'entrée de consigne/de sortie de consigne (210, 410) étant appliquée au composant (9) comparateur, le signal de sortie (610) du composant (9) comparateur pouvant être évalué par la commande séquentielle (2) ou bien l'organe d'égalisation (12, 13) pour le réglage de la croissance de la ligne caractéristique linéarisée étant réglé de telle manière que la valeur de sortie effective (510) puisse être pour l'essentiel égale à la valeur de sortie de consigne (410).

10. Procédé selon la revendication 8 au 9,
**caractérisé par le fait qu'**une autre valeur d'entrée de consigne (220) sortie par la commande séquentielle (2) est appliquée au circuit de linéarisation (1), la valeur de sortie de consigne (420) sortie par la commande séquentielle (2) qui lui appartient pouvant être appliquée au composant (9) comparateur et la valeur de sortie effective (520) de l'autre paire de valeurs d'entrée de consigne/de sortie de consigne (220, 420) pouvant être appliquée au composant (9) comparateur et le signal de sortie (620) du composant (9) comparateur pouvant être évalué par la commande séquentielle (2) et l'organe d'égalisation (11) pour le réglage de la linéarité de la ligne caractéristique étant réglé de telle manière que la valeur de sortie effective (520) puisse être pour l'essentiel égale à la valeur de sortie de consigne (420).

11. Procédé selon l'une des revendications 8 à 10,
**caractérisé par le fait que** l'opération d'égalisation des organes d'égalisation (10, 11, 12, 13) pour la paire de valeurs d'entrée de consigne/de sortie de consigne est répétée jusqu'à ce qu'une divergence prédéfinie entre la valeur de sortie effective (500, 510, 520) et la valeur de sortie de consigne (400, 410, 420) ne soit pas atteinte pour toutes les valeurs de sortie de consigne (400, 410, 420).

12. Procédé selon l'une des revendications 1 à 11,
**caractérisé par le fait que** des lignes caractéristiques différentes sont mémorisées dans la commande séquentielle (2) et que, après la linéarisation de la ligne caractéristique, le signal de sortie (100, 110, 120) du capteur est appliqué au moyen de l'actionneur (8) au circuit de linéarisation (1) en tant que valeur d'entrée.
